# FASCICULE DE BREVET EUROPEEN

(11) **EP 2 628 708 B1**
(45) Date de publication et mention de la délivrance du brevet: **01.07.2015**
(21) Numéro de dépôt: 13154830.7
(22) Date de dépôt: 11.02.2013
(51) Int. Cl.: B81C 1/00, B81B 3/00, B81B 7/00, H01L 21/20

(54) **Substrat microélectronique comprenant une couche de matériau organique enterrée**
Mikroelektronisches Substrat mit einer vergrabenen Schicht organischem Materials
Microelectronic substrate having a buried layer of organic material

(30) Priorité: 15.02.2012 FR 1251397
(43) Date de publication de la demande: 21.08.2013
(73) Titulaire: Commissariat à l'Énergie Atomique et aux Énergies Alternatives, 75015 Paris (FR)
(72) Inventeur: Baillin, Xavier, 38920 CROLLES (FR); Pornin, Jean-Louis, 38920 CROLLES (FR)
(74) Mandataire: Ilgart, Jean-Christophe

(56) Documents cités:
- EP-A2- 1 834 924
- WO-A2-2010/052684
- DE-A1- 19 813 669
- US-A1- 2009 253 245

## Description

### DOMAINE TECHNIQUE

L'invention concerne un substrat microélectronique, ainsi qu'un procédé de réalisation d'un tel substrat, comprenant au moins une couche de matériau organique enterrée apte à servir de couche sacrificielle au substrat. Un tel substrat microélectronique est avantageusement utilisé pour réaliser des dispositifs microélectroniques, par exemple de type MEMS (microsystèmes électromécaniques) et/ou NEMS (nanosystèmes électromécaniques) destinés à être encapsulés. L'invention concerne également un tel dispositif microélectronique, ainsi qu'un procédé de réalisation d'un tel dispositif microélectronique.

### ÉTAT DE LA TECHNIQUE ANTÉRIEURE

Un dispositif microélectronique de type MEMS et/ou NEMS, comportant par exemple une structure résonante, est réalisé à partir d'un substrat de type SOI (« Silicon On Insulator »). La couche supérieure du substrat SOI composée de silicium monocristallin est tout d'abord gravée en mettant en oeuvre une gravure ionique réactive profonde anisotrope (DRIE pour « Deep Reactive Ion Etching ») avec arrêt sur la couche d'oxyde enterrée (appelée BOX pour « Buried Oxide ») du substrat SOI, afin de former les différents éléments, fixes et mobiles, du dispositif microélectronique. Une partie de la couche d'oxyde enterrée est ensuite gravée en utilisant par exemple de l'acide fluorhydrique (HF) sous forme vapeur afin de libérer les éléments mobiles du dispositif microélectronique par rapport au reste de la couche d'oxyde enterrée.

Une encapsulation du dispositif est ensuite réalisée en reportant et en solidarisant de manière hermétique un capot, correspondant par exemple à un second substrat composé de semi-conducteur ou de verre, sur le substrat SOI (packaging de type « Wafer to Wafer », ou W2W). Pour réaliser une atmosphère contrôlée au sein de la cavité (par exemple un vide ou la présence d'un gaz particulier, pression, etc.) nécessaire au bon fonctionnement du dispositif, un matériau getter en couche mince est déposé dans la cavité préalablement à la fermeture de celle-ci, par exemple contre le capot ou sur la face supérieure du substrat.

Un tel procédé de réalisation et d'encapsulation du dispositif microélectronique présente plusieurs inconvénients. Tout d'abord, la gravure humide de la couche d'oxyde enterrée par de l'acide fluorhydrique pose un problème de compatibilité vis-à-vis du matériau getter, généralement composé d'un ou plusieurs métaux, du fait que les métaux ne résistent pas à cet acide. Le matériau getter doit donc être ajouté dans la cavité après cette gravure HF.

Cette gravure de l'oxyde enterré pose également des problèmes liés à la pollution particulaire engendrée par cette gravure, des particules générées par cette gravure pouvant se déposer sur le dispositif microélectronique. Ainsi, lorsque le dispositif comporte par exemple des peignes inter-digités, l'espacement entre ceux de la partie mobile du dispositif et ceux de la partie fixe du dispositif étant de l'ordre de quelques microns dans le cas d'une détection capacitive, ces particules peuvent perturber le fonctionnement du dispositif microélectronique en venant se déposer dans cet espace.

L'utilisation d'un substrat SOI représente également un coût important. En outre, un capot réalisé par report d'un second substrat sur le substrat SOI est encombrant, notamment en raison du cordon de scellement utilisé qui garantit à la fois la tenue mécanique et l'herméticité du packaging réalisé, et qui comporte généralement une largeur de l'ordre de 100 µm.

Enfin, un procédé d'encapsulation par report de substrat requiert bon nombre de précautions à respecter pour obtenir un vide poussé dans la cavité ou une atmosphère rigoureusement contrôlée. En effet, cette encapsulation est réalisée dans une enceinte de scellement dont le niveau de vide minimal pouvant être obtenu est de l'ordre de quelques 10⁻⁶ mbar. Avec une telle pression, il existe un risque de polluer le getter lors du cycle de scellement, et donc de réduire sa capacité de pompage.

Pour d'autres dispositifs tels que des détecteurs infrarouges non refroidis de type bolomètre, il est connu de réaliser ces dispositifs sur un substrat semi-conducteur de type bulk, puis de réaliser une encapsulation de type PCM (« Packaging Couche Mince », ou TFP pour « Thin Film Packaging ») de ces dispositifs. Les micro-bolomètres sont réalisés, ou assemblés, sur la face supérieure du substrat semi-conducteur, en utilisant des couches sacrificielles réalisées sur la face supérieure du substrat. Les dispositifs sont ensuite recouverts d'une couche de matériau sacrificiel, par exemple composée de résine, mise en forme selon la géométrie de la cavité souhaitée. Ce matériau sacrificiel est ensuite recouvert d'une ou plusieurs couches minces d'encapsulation destinées à former le capot. Le matériau sacrificiel est ensuite gravé via des évents réalisés à travers le capot. Enfin, les évents sont bouchés par un matériau de bouchage de façon à rendre la cavité hermétique, et éventuellement sous atmosphère contrôlée si cela est nécessaire au bon fonctionnement des dispositifs. Comme dans le cas du packaging par report de capot, un getter en couche mince peut être déposé sur le substrat préalablement à la mise en oeuvre des étapes d'encapsulation du dispositif microélectronique. Le matériau getter peut également être déposé sur le matériau sacrificiel, préalablement au dépôt de la ou des couches d'encapsulation, formant ensemble le capot (le matériau getter formant alors la paroi interne du capot). Le document FR 2 822 541 décrit la mise en oeuvre d'un tel procédé.

Ce procédé a pour avantage de ne pas faire appel à un substrat SOI, ce qui évite notamment les problèmes liés au coût du substrat lui-même ainsi que ceux liés à la gravure de la couche d'oxyde enterrée.

L'encombrement de l'ensemble obtenu est également réduit par rapport à une encapsulation par report de substrat. Enfin, dans le cas d'un bouchage des évents par un métal, il est possible de réaliser le dépôt de ce métal par évaporation sous un vide proche de 10⁻⁷ mbar, ce qui permet d'obtenir un niveau de vide plus poussé au sein de la cavité. Le matériau de bouchage utilisé peut être un matériau getter.

Par contre, un tel procédé n'est pas adapté à la réalisation de dispositifs de type MEMS et/ou NEMS, notamment lorsqu'ils comportent des parties mobiles, qui nécessitent d'être réalisés dans un substrat SOI. Dans le cas d'un dispositif MEMS/NEMS réalisé au préalable dans un substrat SOI et encapsulé par PCM, il est nécessaire de libérer la structure du dispositif par une gravure humide HF, puis de déposer une résine sacrificielle sur la structure ainsi libérée. Outre l'ajout d'étapes technologiques engendré dans ce cas, il existe également un risque d'affecter la partie mobile du dispositif (chocs, particules, collage sur la partie fixe) avec peu de garantie quand à l'uniformité de l'épaisseur de la résine sacrificielle déposée sur l'ensemble des structures compte tenu de la topologie.

Un autre exemple de substrat microélectronique comportant toutes les caractéristiques du préambule de la revendication 1 est décrit dans le document DE 198 13 669 A1.

### EXPOSÉ DE L'INVENTION

Un but de la présente invention est de proposer un substrat microélectronique à partir duquel il est possible de réaliser et d'encapsuler des dispositifs microélectroniques sans les inconvénients de l'art antérieur précédemment décrits.

Pour cela, la présente invention propose un substrat microélectronique comportant au moins :
- une couche support,
- une couche supérieure composée d'au moins un semi-conducteur,
- une couche composée d'au moins un matériau organique apte à être gravé sélectivement par rapport au semi-conducteur de la couche supérieure par la mise en oeuvre d'une gravure sèche et disposée entre la couche support et la couche supérieure,
et comportant en outre une ou plusieurs portions de matériau diélectrique dont la dureté est supérieure à celle du matériau organique, disposées dans la couche de matériau organique et dont l'épaisseur est sensiblement égale à celle de la couche de matériau organique.

La couche de matériau organique peut correspondre à une couche de résine à base d'au moins un matériau polymère. Le matériau organique est avantageusement un matériau diélectrique. Son épaisseur est par exemple comprise entre quelques microns et quelques dizaines de microns (par exemple comprise entre environ 1 µm et 100 µm). Le matériau de cette couche est dégradable par gravure sèche (par exemple une gravure par un gaz ou un plasma, par exemple de type oxydant) et peut être éliminé sélectivement par rapport au semi-conducteur de la couche supérieure. Le matériau organique peut également présenter des propriétés d'adhérence et éventuellement être photosensible.

Un tel substrat peut donc être utilisé pour la réalisation de dispositifs microélectroniques, avantageusement des dispositifs de type MEMS et/ou NEMS réalisés de manière collective, grâce à la couche de matériau organique servant de couche sacrificielle enterrée, ou enfouie. Par rapport à un substrat massif de type bulk, les dispositifs microélectroniques peuvent être réalisés dans un tel substrat sans mettre en oeuvre d'étape d'assemblage en surface du substrat.

Les éléments des dispositifs microélectroniques peuvent être réalisés directement dans le substrat, et formés par une ou plusieurs parties de la couche supérieure de semi-conducteur.

Le substrat microélectronique proposé peut donc se présenter sous une forme d'un empilement de couches, chacune en forme de disque dont le diamètre est par exemple compris entre environ 100 mm et 300 mm.

Le matériau organique de la couche peut donc être gravé par une gravure sèche qui, contrairement à une gravure humide, n'engendre pas de pollution particulaire, par exemple en utilisant un plasma oxydant.

De plus, un tel substrat est compatible avec une encapsulation de type PCM ou par report de capot (par exemple le report d'un substrat) des dispositifs microélectroniques réalisés dans ce substrat.

L'élément appelé « couche support » peut correspondre à une seule couche ou à plusieurs couches empilées.

Le substrat peut être réalisé à moindre coût si le matériau de la couche support est peu coûteux, comme par exemple en métal, en verre ou en silicium polycristallin (contrairement à un substrat SOI). De façon générale, toute couche de matériau d'épaisseur comprise entre quelques centaines de microns et quelques mm, présentant une planéité (ou TTV pour « Total Thickness Variation ») inférieure à environ 10 µm et dont la flèche est inférieure à environ 100 µm, peut servir de couche support.

Le matériau organique peut être une résine, par exemple photosensible. Cette résine est avantageusement de polarité négative, comme par exemple du polyimide ou du BCB (Benzocyclobutène). Pour ce type de résine, la couche de matériau organique présente alors une adhérence vis-à-vis de la couche support et de la couche supérieure, facilitant ainsi la réalisation du substrat. De façon générale, tout polymère qui est dégradable sélectivement par gravure sèche vis-à-vis de la couche supérieure peut être utilisé en tant que matériau organique dans ce substrat. Le polymère peut être apte à coller la couche support et la couche supérieure.

Le substrat microélectronique peut comporter en outre au moins une couche de matériau getter disposée entre la couche support et la couche de matériau organique. Ainsi, lors de la réalisation d'un dispositif microélectronique dans le substrat, la gravure du matériau organique réalisée pour libérer le dispositif microélectronique (dont des éléments, tels que des parties fixes ou mobiles, sont formés par des parties de la couche supérieure de semi-conducteur) révèle une partie de la couche de matériau getter se trouvant sous le matériau organique gravé et qui est destinée à être encapsulée dans la cavité dans laquelle est encapsulé le dispositif microélectronique, ce matériau contribuant à réaliser une absorption et/ou une adsorption gazeuse dans la cavité d'encapsulation du dispositif.

Le substrat peut comporter en outre au moins deux autres couches, par exemple diélectriques, solidarisées directement l'une contre l'autre et disposées entre la couche de matériau organique et la couche supérieure. Ces deux couches, qui sont solidarisées l'une à l'autre par collage direct (sans matériau d'adhérence disposé entre ces deux couches), peuvent être composées d'oxyde de semi-conducteur et/ou de nitrure de semi-conducteur. Le coût d'un tel substrat est inférieur à celui d'un substrat SOI. De plus, la couche organique sacrificielle, de part sa faible rigidité mécanique, limite les contraintes résiduelles dues à l'assemblage entre la couche support et la couche supérieure lorsqu'un collage direct entre ces deux couches est réalisé, ce collage étant réalisé à une température inférieure à la température de dégradation du matériau organique.

Le substrat peut comporter en outre une ou plusieurs portions de matériau diélectrique dont la dureté est supérieure à celle du matériau organique, disposées dans la couche de matériau organique et dont l'épaisseur peut être sensiblement égale à celle de la couche de matériau organique. Ces portions de matériau diélectrique peuvent être avantageusement composées d'oxyde et/ou de nitrure de semi-conducteur. De telles portions de matériau forment des espaceurs, ou plots, ou butées, rigides vis-à-vis des deux couches disposées contre la couche de matériau organique de chaque côté de celle-ci. Ainsi, lors de la réalisation du substrat, la couche de matériau organique n'est pas écrasée de manière non uniforme par ces couches étant donné que les portions de matériau rigide assurent un espacement sensiblement constant entre ces couches qui correspond à l'épaisseur de la couche de matériau organique, ces couches étant donc positionnées de manière parallèle l'une par rapport à l'autre.

Le substrat peut comporter en outre un ou plusieurs trous réalisés à travers la couche de matériau organique.

Le substrat peut comporter en outre au moins une portion de matériau diélectrique (avantageusement composée d'oxyde de semi-conducteur et/ou de nitrure de semi-conducteur) disposée dans la couche de matériau organique, pouvant former un contour fermé autour d'au moins une région de la couche de matériau organique. Au moins une des portions de matériau diélectrique disposées dans la couche de matériau organique peut former un contour fermé autour d'au moins une région de la couche de matériau organique. Cette portion de matériau diélectrique peut donc délimiter une région de matériau organique qui, lors de la réalisation d'un dispositif microélectronique dans le substrat au niveau de cette région, est destinée à être gravée lors de la libération du dispositif microélectronique. Le fait que la portion de matériau diélectrique forme un contour fermé de cette région permet de bien délimiter la région de matériau organique qui sera gravée lors de la libération du dispositif microélectronique. L'épaisseur de cette portion de matériau diélectrique peut être sensiblement égale à celle de la couche de matériau organique.

L'invention concerne également un dispositif microélectronique comportant un substrat microélectronique tel que défini précédemment, comprenant au moins une portion de la couche supérieure suspendue au-dessus de la couche support. Cette portion suspendue peut être obtenue par la mise en oeuvre d'une gravure sèche d'une partie de la couche de matériau organique. Etant donné que le matériau organique peut être gravé sélectivement par rapport au semi-conducteur de la couche supérieure du substrat, on peut donc libérer les parties, par exemple des parties mobiles, du dispositif formées par une ou plusieurs portions de la couche supérieure.

L'invention concerne également un procédé de réalisation d'un substrat microélectronique, comportant au moins les étapes de :
- réalisation d'une couche comportant ou composée d'au moins un matériau organique sur une couche support ;
- réalisation d'une couche supérieure comportant ou composée d'au moins un semi-conducteur sur la couche de matériau organique, le matériau organique étant apte à être gravé sélectivement par rapport au semi-conducteur de la couche supérieure par la mise en oeuvre d'une gravure sèche.

L'invention concerne également un procédé de réalisation d'un substrat microélectronique, comportant au moins les étapes de :
- réalisation d'une couche comportant ou composée d'au moins un matériau organique sur une couche support ;
- réalisation d'une couche supérieure comportant ou composée d'au moins un semi-conducteur sur la couche de matériau organique, le matériau organique étant apte à être gravé sélectivement par rapport au semi-conducteur de la couche supérieure par la mise en oeuvre d'une gravure sèche ;
et comportant en outre, avant la réalisation de la couche de matériau organique, une étape de réalisation d'une ou plusieurs portions d'un matériau diélectrique dont la dureté est supérieure à celle du matériau organique, sur la couche support, dont l'épaisseur est sensiblement égale à celle de la couche de matériau organique, la couche de matériau organique étant réalisée ensuite sur la couche support, autour de ladite ou desdites portions.

Le procédé de réalisation du substrat microélectronique peut comporter en outre, avant la réalisation de la couche de matériau organique, une étape de réalisation d'au moins une couche de matériau getter sur la couche support, la couche de matériau organique étant réalisée sur la couche de matériau getter. La ou les portions de matériau diélectrique peuvent être réalisées sur la couche de matériau getter.

La réalisation de la couche supérieure sur la couche de matériau organique peut comporter au moins une étape de collage direct entre deux autres couches, l'une pouvant être disposée contre la couche supérieure et l'autre pouvant être disposée contre la couche de matériau organique. Ces couches de collage direct sont avantageusement composées d'au moins un matériau diélectrique.

Le procédé de réalisation du substrat peut comporter en outre, avant la réalisation de la couche de matériau organique, une étape de réalisation d'une ou plusieurs portions d'un matériau diélectrique dont la dureté est supérieure à celle du matériau organique, sur la couche support ou, lorsque le procédé comporte une étape de réalisation d'au moins une couche de matériau getter sur la couche support, sur la couche de matériau getter, dont l'épaisseur peut être sensiblement égale à celle de la couche de matériau organique, la couche de matériau organique pouvant être réalisée ensuite sur la couche support ou sur la couche de matériau getter, autour de ladite ou desdites portions.

Le procédé de réalisation du substrat peut comporter en outre, avant la réalisation de la couche supérieure, une étape de réalisation d'un ou plusieurs trous à travers la couche de matériau organique. Ainsi, lors de la réalisation de la couche supérieure sur la couche de matériau organique qui peut impliquer un écrasement de la couche de matériau organique, ce ou ces trous permettent un meilleur contrôle de cet écrasement et notamment de la déformation de la couche de matériau organique.

Le procédé de réalisation du substrat peut comporter en outre, avant la réalisation de la couche de matériau organique, une étape de réalisation d'au moins une portion de matériau diélectrique (avantageusement de l'oxyde de semi-conducteur et/ou du nitrure de semi-conducteur) sur la couche support ou, lorsque le procédé comporte une étape de réalisation d'au moins une couche de matériau getter sur la couche support, sur la couche de matériau getter, ladite portion pouvant former un contour fermé autour d'au moins une région de la couche de matériau organique réalisée ensuite sur la couche support ou sur la couche de matériau getter.

Le procédé peut comporter en outre la réalisation d'au moins une des portions de matériau diélectrique telle que ladite portion forme un contour fermé autour d'au moins une région de la couche de matériau organique.

L'invention concerne également un procédé de réalisation d'au moins un dispositif microélectronique, comportant au moins les étapes de :
- réalisation du dispositif microélectronique dans la couche supérieure d'un substrat microélectronique tel que défini précédemment ;
- élimination par gravure sèche d'une partie de la couche de matériau organique disposée sous le dispositif microélectronique tel que le dispositif microélectronique comporte au moins une portion de la couche supérieure suspendue au-dessus de la couche support.

Le procédé de réalisation du dispositif microélectronique peut comporter en outre, entre l'étape de réalisation du dispositif microélectronique et l'étape d'élimination d'une partie de la couche de matériau organique, au moins les étapes de :
- réalisation, sur la couche supérieure du substrat microélectronique, d'une portion de matériau apte à être gravé sélectivement par rapport au matériau semi-conducteur de la couche supérieure et recouvrant le dispositif microélectronique ;
- dépôt d'au moins une couche d'encapsulation sur la portion de matériau recouvrant le dispositif microélectronique ;
- gravure de la portion de matériau recouvrant le dispositif microélectronique à travers au moins une ouverture réalisée à travers la couche d'encapsulation ;
et pouvant comporter en outre, après l'étape d'élimination d'une partie de la couche de matériau organique disposée sous le dispositif microélectronique, une étape de fermeture hermétique de la ou des ouvertures réalisées à travers la couche d'encapsulation.

L'étape de gravure de la portion de matériau recouvrant le dispositif microélectronique et l'étape d'élimination d'une partie de la couche de matériau organique peuvent correspondre à une seule étape de gravure sèche. On peut donc libérer le dispositif microélectronique et la cavité dans laquelle est encapsulé le dispositif microélectronique en une seule étape technologique.

De plus, l'ensemble de la structure peut être dégazé en un seul cycle avant l'étape de bouchage, garantissant ainsi un dégazage uniforme et permettant d'assurer un bouchage dans des conditions de pression maitrisées.

Le procédé peut également permettre d'encapsuler plusieurs composants dans une même atmosphère.

Le procédé peut comporter en outre, entre l'étape de réalisation du dispositif microélectronique et l'étape d'élimination d'une partie de la couche de matériau organique, une étape de report et de scellement d'un capot (par exemple en silicium ou en verre) sur la couche supérieure, dans lequel l'élimination d'une partie de la couche de matériau organique peut être réalisée par au moins une ouverture formée à travers le capot, et pouvant comporter en outre une étape de fermeture hermétique de l'ouverture réalisée à travers le capot.

Le scellement du capot peut correspondre à un scellement anodique, un scellement métallique ou encore un scellement direct.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 7 représentent des vues en coupe de profil ou de dessus de substrats microélectroniques à couche de matériau organique enfouie, objets de la présente invention, selon plusieurs modes de réalisation ;
- les figures 8A à 8F représentent les étapes d'un procédé de réalisation d'un dispositif microélectronique dans un substrat microélectronique à couche de matériau organique enfouie, également objet de la présente invention ;
- la figure 9 représente un dispositif microélectronique réalisé à partir d'un substrat microélectronique à couche de matériau organique enfouie, également objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

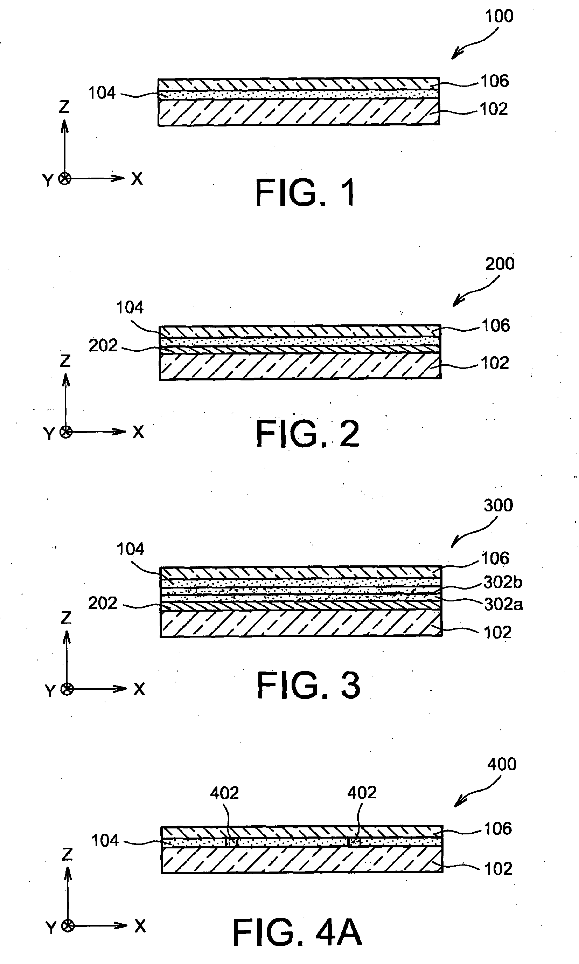

On se réfère tout d'abord à la figure 1 qui représente un substrat microélectronique 100 à couche de matériau organique enfouie, ou enterrée, selon un premier mode de réalisation.

Le substrat 100 comporte une couche support 102, dont l'épaisseur est par exemple supérieure ou égale à environ 100 µm, servant de support mécanique aux autres éléments du substrat 100.

Cette couche support 102 est composée de semi-conducteur tel que du silicium monocristallin ou polycristallin, ou de tout autre matériau permettant de réaliser la couche support 102 sous la forme d'un substrat circulaire plan dont le diamètre est par exemple compris entre environ 100 mm et 300 mm. La couche support 102 peut également être composée de verre ou tout autre matériau suffisamment rigide pour empêcher ou limiter la courbure du substrat semi-conducteur 100 (métal, polymère, ...).

La couche support 102 est recouverte par une couche 104 composée d'au moins un matériau organique, par exemple une résine ou un matériau de type polyimide. Selon sa nature, le matériau organique peut présenter des propriétés adhésives contribuant à la liaison mécanique entre la couche support 102 et une couche supérieure 106 composée d'au moins un semi-conducteur et recouvrant la couche organique 104.

Ainsi, la couche organique 104 peut être composée d'un ou plusieurs matériaux généralement utilisés pour réaliser un scellement entre deux substrats, tels que des résines photosensibles de polarité négative qui présentent des propriétés adhésives, par exemple de type BCB. De manière générale, la couche organique 104 peut être composée de n'importe quel matériau organique résistant à une température comprise entre 250°C et 400°C et susceptible d'être détruit par gravure sèche, par exemple en utilisant un ou plusieurs gaz tel qu'un gaz fluoré ou chloré de type SF₆ et/ou CF₄, et/ou un plasma, par exemple un plasma oxydant. Un tel matériau peut supporter les étapes technologiques mises en oeuvre lors de la réalisation d'un dispositif microélectronique dans la couche supérieure 106, tout en étant compatible avec une élimination ultérieure de celui-ci par une gravure autre qu'une gravure HF, par exemple par un plasma oxydant. La couche 104 a par exemple une épaisseur comprise entre environ 1 µm et 100 µm. Le matériau de la couche 104 est avantageusement diélectrique. Cette couche 104 servira par la suite de couche sacrificielle lors de la réalisation de dispositifs microélectroniques dans le substrat 100.

Enfin, le substrat 100 comporte la couche supérieure 106 composée de semi-conducteur tel que par exemple du silicium monocristallin, disposée sur la couche organique 104 et dont l'épaisseur est comprise entre quelques microns et quelques dizaines de microns, par exemple entre environ 1 µm et 100 µm. Le matériau de la couche supérieure 106 est choisi afin de pouvoir servir ensuite à la réalisation de dispositifs microélectroniques, par exemple de type MEMS et/ou NEMS, dans cette couche supérieure 106.

Le substrat 100 est réalisé en déposant tout d'abord la couche organique 104 sur la couche support 102, par exemple par la mise en oeuvre d'une étape de « spin coating » (dépôt à la tournette). La couche supérieure 106 est ensuite assemblée à la couche organique 104, par exemple par thermocompression. Cette thermocompression peut être réalisée dans une enceinte de scellement sous vide primaire et à une température comprise entre environ 200°C et 300°C de façon à pouvoir réticuler le matériau organique de la couche 104. Si l'épaisseur de la couche supérieure 106 est supérieure à l'épaisseur finale souhaitée, cette épaisseur de la couche sacrificielle 106 est réduite par exemple via la mise en oeuvre d'un usinage mécanique par meulage. Que la couche supérieure 106 ait subie ou non cette étape d'usinage, la face avant de la couche supérieure 106 (face opposée à celle en contact avec la couche organique 104) peut subir un polissage mécano-chimique (CMP) réduisant les topologies de surface de cette face avant.

La figure 2 représente un substrat 200 à couche de matériau organique enterrée selon un deuxième mode de réalisation.

Par rapport au substrat 100 précédemment décrit, le substrat 200 comporte une couche de matériau getter 202, par exemple composée d'au moins un métal, disposée entre la couche support 102 et la couche organique 104. Ainsi, lorsqu'une partie de la couche organique 104 est éliminée lors de la libération d'un dispositif microélectronique réalisé dans la couche supérieure 106, la partie de matériau getter de la couche 202 se trouvant sous la partie gravée de la couche organique 104 se retrouve alors exposée à l'atmosphère de la cavité dans laquelle est encapsulé le dispositif microélectronique, contribuant à contrôler l'atmosphère dans la cavité lors de l'activation thermique ultérieure du matériau getter.

Le substrat 200 est obtenu en mettant en oeuvre les mêmes étapes que celles précédemment décrites pour la réalisation du substrat 100, excepté que, préalablement au dépôt de la couche organique 104, la couche de matériau getter 202 est tout d'abord déposée par PVD (dépôt physique en phase vapeur), sur la couche support 102, la couche organique 104 étant ensuite déposée sur la couche de matériau getter 202.

La figure 3 représente un substrat 300 à couche de matériau organique enterrée, selon un troisième mode de réalisation.

Comme le substrat 200 précédemment décrit, le substrat 300 comporte la couche support 102, la couche de matériau getter 202, la couche de matériau organique 104 et la couche supérieure 106 de semi-conducteur. Le substrat 300 comporte en outre, entre la couche supérieure 106 et la couche organique 104, deux autres couches 302a, 302b, ici des couches diélectriques composées d'oxyde de silicium, assemblées l'une contre l'autre par collage direct.

Ces deux couches 302a, 302b sont présentes dans le substrat 300 en raison des étapes mises en oeuvre pour réaliser le substrat 300. Une première partie du substrat 300 est tout d'abord formée en réalisant la couche de matériau getter 202 et la couche organique 104 sur la couche support 102 comme précédemment décrit pour le substrat 200. La couche 302a est ensuite réalisée sur la couche organique 104, par exemple par CVD (dépôt chimique en phase vapeur). Une seconde partie du substrat 300 est réalisée indépendamment de la première partie en formant la couche 302b sur la couche supérieure 106, par exemple par une oxydation thermique d'une face de la couche supérieure de semi-conducteur 106. Les couches 302a, 302b sont ensuite polies par CMP. Les deux parties réalisées indépendamment l'une de l'autre sont ensuite assemblées par la mise en oeuvre d'un collage direct des couches 302a, 302b l'une contre l'autre.

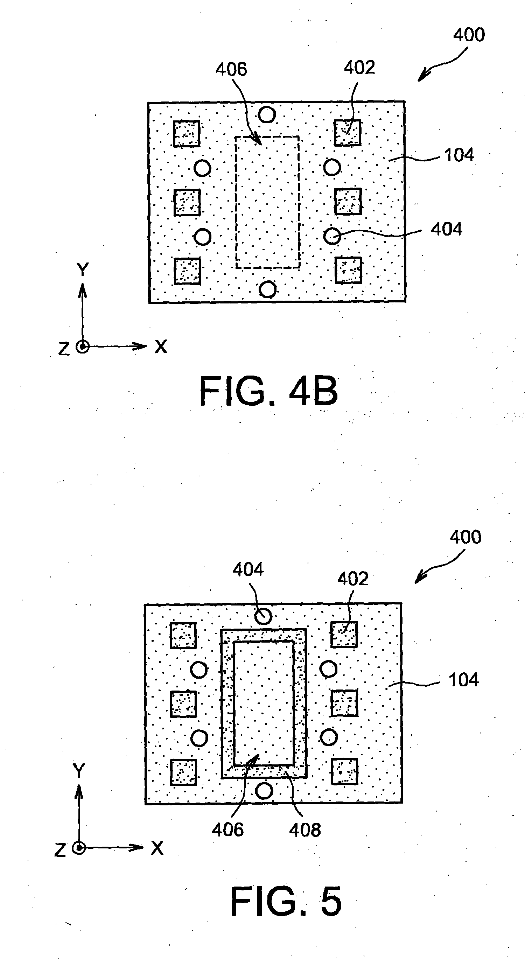

Les figures 4A et 4B représentent respectivement une vue en coupe de profil et une vue en coupe de dessus d'un substrat 400 à couche de matériau organique enterrée selon un quatrième mode de réalisation.

Comme le substrat 100 précédemment décrit, le substrat 400 comporte la couche support 102, la couche de matériau organique enterrée 104 et la couche supérieure de semi-conducteur 106. Le substrat 400 comporte en outre des portions 402 d'un matériau diélectrique, ici de l'oxyde de silicium, interposées entre la couche support 102 et la couche supérieure 106, dans la couche de matériau organique 104. Ces portions 402 forment des cales, ou butées, permettant de maintenir la couche support 102 et la couche supérieure 106 parallèles l'une par rapport à l'autre lors de la réalisation du substrat 400. En effet, lorsque la couche supérieure 106 est assemblée à la couche organique 104, par exemple par thermocompression, la couche supérieure 106 écrase la couche organique 104 qui peut se déformer de manière irrégulière et entrainer une disposition non parallèle de la couche supérieure 106 par rapport à la couche support 102. En formant les portions 402 au sein de la couche organique 104 avec une épaisseur égale à celle de la couche organique 104, ces portions 402 vont former des butées sur lesquelles la couche supérieure 106 va s'appuyer lors de l'assemblage avec la couche organique 104, facilitant ainsi le positionnement parallèle de la couche supérieure 106 par rapport à la couche support 102.

Dans ce quatrième mode de réalisation, des trous 404 sont également réalisés à travers la couche organique 104 afin de mieux contrôler l'écrasement de la couche organique 104 lors de l'assemblage de la couche supérieure 106 sur la couche organique 104. Les trous 404 et les portions 402 sont réalisés autour d'une zone 406, délimitée symboliquement par des pointillées sur la figure 4B, représentant la portion de la couche organique 104 qui est destinée à être gravée ultérieurement lors de la libération d'un dispositif microélectronique réalisé dans la couche supérieure 106, au-dessus de cette zone 406 (les trous 404 et les portions 402 sont réalisés autour de cette zone 406).

Les portions 402 sont réalisées sur la couche support 102 préalablement au dépôt de la couche organique 104, en déposant tout d'abord une couche de matériau diélectrique sur la couche support 102, puis en gravant cette couche selon les motifs des portions 402. Le matériau organique de la couche 104 est ensuite déposé sur la couche support 102. Le matériau organique déposé sur les portions 402 est supprimé avant de poursuivre la réalisation du substrat 400. Les trous 404 sont ensuite réalisés par photolithographie et gravure à travers le matériau organique de la couche 104. Le procédé est ensuite achevé de manière analogue à celle précédemment décrite pour les précédents substrats (réalisation de la couche supérieure 106, CMP, ...).

La figure 5 représente une vue en coupe de dessus du substrat 400 à couche sacrificielle organique enterrée selon une variante du quatrième mode de réalisation.

Dans cette variante de réalisation, la zone 406 est délimitée par une portion de matériau diélectrique 408 formant un cordon entourant le matériau organique de cette zone 106. Le matériau diélectrique de la portion 408 correspond par exemple à celui formant les portions 402 (ici du SiO₂). De plus, comme les portions 402, la portion 408 peut s'étendre à travers toute l'épaisseur de la couche organique 104, entre la couche support 102 et la couche supérieure 106. La portion 408 permet de bien délimiter la portion de matériau organique à graver, qui correspond à la partie de la couche organique 104 se trouvant à l'intérieur de la zone délimitée par la portion 408. Outre cette fonction de délimitation, cette portion 408 permet également d'améliorer l'étanchéité de la cavité qui sera obtenue en gravant la zone 406 de la couche organique 104.

La portion de matériau diélectrique 408 et les portions 402 peuvent être réalisées par la mise en oeuvre d'étapes communes de dépôt de matériau diélectrique, de photolithographie et de gravure de ce matériau diélectrique.

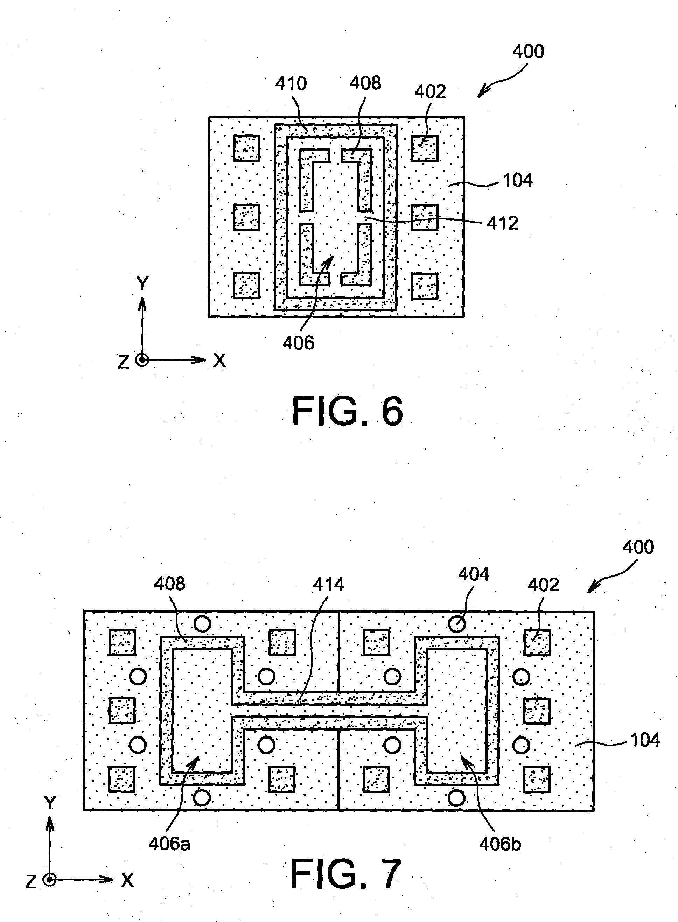

La figure 6 représente une vue en coupe de dessus du substrat 400 à couche sacrificielle organique enterrée selon une autre variante du quatrième mode de réalisation.

Dans cette variante de réalisation, la zone 406 est délimitée par la portion de matériau diélectrique 408 ainsi que par une seconde portion 410 entourant la première portion 408. Dans cette variante, étant donné que la première portion 408 n'a pas un contour fermé (présence de canaux 412 faisant communiquer la zone 406 délimitée par la première portion 408 avec la zone délimitée par la deuxième portion 410 qui elle a un contour fermé), on augmente le volume de la zone de matériau organique qui sera gravé lors de la libération du dispositif microélectronique réalisé dans le substrat 400, ce qui permet de réduire la pression dans la cavité formée pour un même nombre de moles de gaz piégées dans cette cavité.

Une autre variante de réalisation du substrat 400 est représentée sur la figure 7.

Dans cette variante, la portion 408 de matériau diélectrique délimite deux zones 406a, 406b destinées à former deux cavités dans lesquelles seront encapsulés deux dispositifs microélectroniques. La portion 408 délimite également une zone 414 destinée à former un canal faisant communiquer les deux cavités formées au niveau des zones 406a, 406b. Ainsi, les deux dispositifs microélectroniques pourront être encapsulés hermétiquement dans deux cavités différentes dans lesquelles règne une même atmosphère.

Les éléments du substrat 400 précédemment décrits en liaison avec les figures 4 à 7 (portions diélectriques 402, 408, 410, trous 404) peuvent être réalisés dans les substrats précédemment décrits.

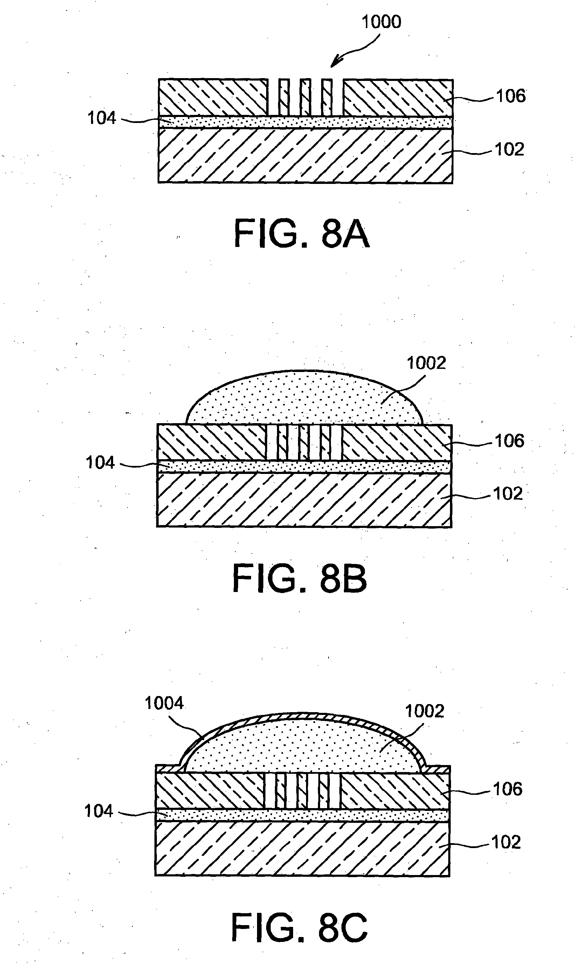

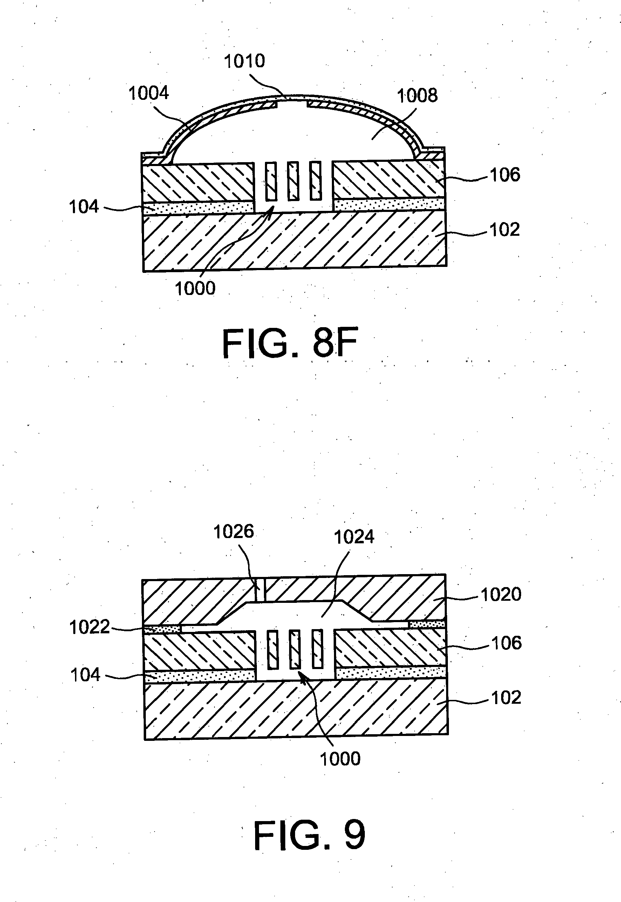

On se réfère maintenant aux figures 8A à 8F qui représentent les étapes d'un procédé de réalisation d'un dispositif microélectronique 1000 à partir d'un substrat à couche sacrificielle de matériau organique enterrée, correspondant ici au substrat 100 précédemment décrit.

Comme représenté sur la figure 8A, les différentes parties du dispositif 1000 sont réalisées dans la couche supérieure 106, par exemple via des étapes de photolithographie et de gravure (avec arrêt sur la couche organique enterrée 104).

On réalise ensuite une portion de matériau sacrificiel 1002 sur le dispositif 1000, dont la forme et les dimensions correspondent à la cavité dans laquelle le dispositif 1000 est destiné à être encapsulé. La portion de matériau sacrificiel 1002 est par exemple réalisée en déposant une couche de ce matériau sacrificiel sur la couche supérieure 106, puis en réalisant une mise en forme par photolithographie et gravure de cette couche de matériau sacrificiel, et éventuellement par un traitement thermique permettant de faire fluer le matériau sacrificiel en vue de lui donner une forme plus arrondie (figure 8B). De manière avantageuse, la portion 1002 est composée d'un matériau organique similaire à celui de la couche 104.

Comme représenté sur la figure 8C, une couche d'encapsulation 1004 est ensuite déposée sur la portion de matériau sacrificiel 1002. Cette couche d'encapsulation peut être composée d'oxyde et/ou de nitrure de semi-conducteur (par exemple du SiO₂ et/ou du SiN), et avoir une épaisseur de l'ordre de quelques microns. Cette couche d'encapsulation 1004 est destinée à former le capot de la cavité dans laquelle le dispositif 1000 est destiné à être encapsulé. En variante, plusieurs couches d'encapsulation peuvent être déposées et superposées sur la portion de matériau sacrificiel 1002. Il est par exemple possible de déposer tout d'abord une couche de matériau getter (par exemple du titane ou du zirconium) recouvrant la portion de matériau sacrificiel 1002. Une ou plusieurs autres couches d'encapsulation sont ensuite déposées sur la couche de matériau getter. On forme dans ce cas un capot intégrant, au niveau de sa face intérieure, un matériau getter.

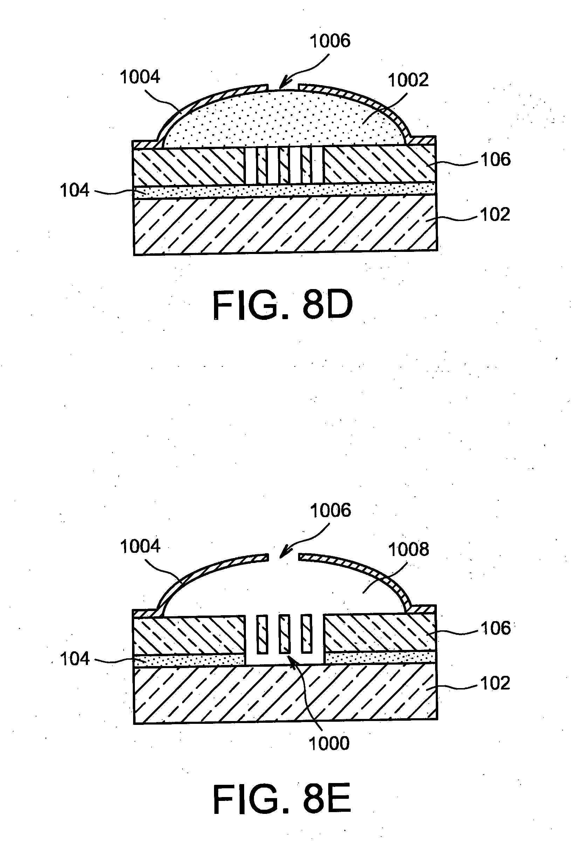

Comme représenté sur la figure 8D, on réalise ensuite une ouverture 1006, ou évent, à travers la ou les couches d'encapsulation 1004. Il est possible de réaliser plusieurs ouvertures à travers la couche d'encapsulation 1004, notamment en périphérie du dispositif 1000. Le diamètre de l'ouverture 1006 est compris entre environ 1 µm et quelques microns.

On réalise ensuite la gravure de la portion de matériau sacrificiel 1002 à travers la ou les ouvertures 1006 précédemment réalisées dans la ou les couches d'encapsulation 1004 (figure 8E). Cette gravure du matériau sacrificiel de la portion 1002 peut être réalisée par un plasma oxydant à une température comprise entre environ 200°C et 300°C. Lorsque le matériau de la portion 1002 est de nature similaire à celui de la couche organique 104, cette étape de gravure, telle une gravure sèche, de la portion de matériau sacrificiel 1002 peut réaliser en même temps une gravure d'une partie de la couche organique 104 se trouvant sous le dispositif microélectronique 1000 et qui correspond à la zone destinée à être encapsulée dans la cavité, libérant ainsi les différentes parties du dispositif 1000, ces différentes parties correspondant par exemple à des parties mobiles lorsque le dispositif 1000 est du type MEMS / NEMS. En variante, la gravure de la portion 1002 et de la partie de la couche organique 104 peut être obtenue par la mise en oeuvre de deux étapes de gravure distinctes, la gravure de la partie de la couche organique 104 correspondant à une gravure sèche.

Du fait que le matériau organique de la couche 104 soit apte à être gravé sélectivement par rapport au semi-conducteur de la couche supérieure 106, la gravure sèche réalisée pour supprimer une partie de la couche sacrificielle 104 ne dégrade pas le matériau de la couche supérieure 106.

On obtient ainsi une cavité 1008 dans laquelle est encapsulé le dispositif microélectronique 1000, la ou les couches d'encapsulation 1004 formant le capot de cette cavité 1008.

On bouche ensuite hermétiquement la ou les ouvertures 1006 réalisées précédemment à travers la ou les couches d'encapsulation 1004, en déposant par exemple une couche hermétique 1010 d'oxyde ou de nitrure de semi-conducteur, ou de métal. L'épaisseur de la couche hermétique 1010 peut être comprise entre 1 et quelques microns (par exemple inférieure ou égale à 10 µm) selon la taille des ouvertures 1006 à boucher.

Cette fermeture hermétique de la cavité 1008 peut être réalisée dans une atmosphère contrôlée (pression, gaz, ...) correspondant à l'atmosphère souhaitée dans la cavité 1008.

La figure 9 représente un dispositif microélectronique 1000 encapsulé non pas par PCM, mais par report d'un capot 1020. Ce capot 1020, par exemple composé de semi-conducteur tel que du silicium, ou de verre, peut être solidarisé à la couche supérieure 106 par l'intermédiaire d'un cordon de scellement 1022, obtenu par exemple par scellement anodique ou scellement métallique, ou encore par un scellement direct entre le capot 1020 et la couche supérieure 106.

Le capot 1020 comporte une partie gravée formant au moins une partie de la cavité 1024 dans laquelle le dispositif 1000 est encapsulé. Lorsque le capot 1020 est reporté sur la couche supérieure 106, la couche organique 104 peut ne pas être encore gravée.

Afin de libérer le dispositif 1000, une ouverture 1026 (ou plusieurs ouvertures) est réalisée alors à travers le capot 1020, formant ainsi un accès au dispositif 1000. On élimine ensuite la partie de la couche organique 104 se trouvant sous le dispositif 1000, via la mise en oeuvre d'étapes similaires à celles précédemment décrites, afin de libérer le dispositif 1000 (gravure sèche). L'ouverture 1026 est ensuite bouchée hermétiquement via le dépôt d'un matériau de bouchage sur le capot 1020, localisé ou non au niveau de l'ouverture 1026.

En variante, il est possible de réaliser tout d'abord le dispositif 1000, puis de l'encapsuler via le report du capot 1020.

Sur les figures 8A à 8F et 9, un seul dispositif microélectronique 1000 est encapsulé dans la cavité 1008 ou 1024. Il est toutefois possible d'encapsuler plusieurs dispositifs microélectroniques dans une même atmosphère, par exemple en encapsulant plusieurs dispositifs microélectroniques dans une même cavité ou bien en réalisant une encapsulation collective de plusieurs dispositifs microélectroniques dans différentes cavités.

Dans tous les modes de réalisation précédemment décrits, le substrat microélectronique peut comporter une ou plusieurs portions de matériau diélectrique dont la dureté est supérieure à celle du matériau organique, disposées dans la couche de matériau organique et dont l'épaisseur est sensiblement égale à celle de la couche de matériau organique.

## Revendications

1. Substrat microélectronique (100 - 400) comportant au moins :
- une couche support (102),
- une couche supérieure (106) composée d'au moins un semi-conducteur,
- une couche (104) composée d'au moins un matériau organique apte à être gravé sélectivement par rapport au semi-conducteur de la couche supérieure (106) par la mise en oeuvre d'une gravure sèche et disposée entre la couche support (102) et la couche supérieure (106),
**caractérisé en ce qu'**il comporte en outre une ou plusieurs portions (402, 408, 410) de matériau diélectrique dont la dureté est supérieure à celle du matériau organique, disposées dans la couche de matériau organique (104) et dont l'épaisseur est sensiblement égale à celle de la couche de matériau organique (104).

2. Substrat microélectronique (100 - 400) selon la revendication 1, dans lequel le matériau organique est une résine photosensible.

3. Substrat microélectronique (200, 300) selon l'une des revendications précédentes, comportant en outre au moins une couche de matériau getter (202) disposée entre la couche support (102) et la couche de matériau organique (104).

4. Substrat microélectronique (300) selon l'une des revendications précédentes, comportant en outre au moins deux autres couches (302a, 302b) solidarisées directement l'une contre l'autre et disposées entre la couche de matériau organique (104) et la couche supérieure (106).

5. Substrat microélectronique (400) selon l'une des revendications précédentes, dans lequel au moins une des portions (408, 410) de matériau diélectrique disposées dans la couche de matériau organique (104) forme un contour fermé autour d'au moins une région (406) de la couche de matériau organique (104).

6. Dispositif microélectronique (1000) comportant un substrat microélectronique (100 - 400) selon l'une des revendications précédentes, comprenant au moins une portion de la couche supérieure (106) suspendue au-dessus de la couche support (102).

7. Procédé de réalisation d'un substrat microélectronique (100 - 400), comportant au moins les étapes de :
- réalisation d'une couche (104) composée d'au moins un matériau organique sur une couche support (102) ;
- réalisation d'une couche supérieure (106) composée d'au moins un semi-conducteur sur la couche de matériau organique (104), le matériau organique étant apte à être gravé sélectivement par rapport au semi-conducteur de la couche supérieure (106) par la mise en oeuvre d'une gravure sèche ;
**caractérisé en ce qu'**il comporte en outre, avant la réalisation de la couche de matériau organique (104), une étape de réalisation d'une ou plusieurs portions (402, 408, 410) d'un matériau diélectrique dont la dureté est supérieure à celle du matériau organique, sur la couche support (102), dont l'épaisseur est sensiblement égale à celle de la couche de matériau organique (104), la couche de matériau organique (104) étant réalisée ensuite sur la couche support (102), autour de ladite ou desdites portions (402, 408, 410).

8. Procédé selon la revendication 7, comportant en outre, avant la réalisation de la couche de matériau organique (104), une étape de réalisation d'au moins une couche de matériau getter (202) sur la couche support (102), la couche de matériau organique (104) et la ou les portions (402, 408, 410) de matériau diélectrique étant réalisées sur la couche de matériau getter (202).

9. Procédé selon l'une des revendications 7 ou 8, dans lequel la réalisation de la couche supérieure (106) sur la couche de matériau organique (104) comporte au moins une étape de collage direct entre deux autres couches (302a, 302b), l'une (302b) étant disposée contre la couche supérieure (106) et l'autre (302a) étant disposée contre la couche de matériau organique (104).

10. Procédé selon l'une des revendications 7 à 9, comportant en outre, avant la réalisation de la couche supérieure (106), une étape de réalisation d'un ou plusieurs trous (404) à travers la couche de matériau organique (104).

11. Procédé selon l'une des revendications 7 à 10, comportant en outre la réalisation d'au moins une des portions (408, 410) de matériau diélectrique telle que ladite portion (408, 410) forme un contour fermé autour d'au moins une région (406) de la couche de matériau organique (104).

12. Procédé de réalisation d'au moins un dispositif microélectronique (1000), comportant au moins les étapes de :
- réalisation du dispositif microélectronique (1000) dans la couche supérieure (106) d'un substrat microélectronique (100 - 400) selon l'une des revendications 1 à 5 ;
- élimination par gravure sèche d'une partie de la couche de matériau organique (104) disposée sous le dispositif microélectronique (1000) tel que le dispositif microélectronique (1000) comporte au moins une portion de la couche supérieure (106) suspendue au-dessus de la couche support (102).

13. Procédé selon la revendication 12, comportant en outre, entre l'étape de réalisation du dispositif microélectronique (1000) et l'étape d'élimination d'une partie de la couche de matériau organique (104), au moins les étapes de :
- réalisation, sur la couche supérieure (106) du substrat microélectronique (100 - 400), d'une portion de matériau (1002) apte à être gravé sélectivement par rapport au matériau semi-conducteur de la couche supérieure (106) et recouvrant le dispositif microélectronique (1000),
- dépôt d'au moins une couche d'encapsulation (1004) sur la portion de matériau (1002) recouvrant le dispositif microélectronique (1000) ;
- gravure de la portion de matériau (1002) recouvrant le dispositif microélectronique (1000) à travers au moins une ouverture (1006) réalisée à travers la couche d'encapsulation (1004) ;
et comportant en outre, après l'étape d'élimination d'une partie de la couche de matériau organique (104) disposée sous le dispositif microélectronique (1000), une étape de fermeture hermétique de la ou des ouvertures (1006) réalisées à travers la couche d'encapsulation (1004).

14. Procédé selon la revendication 13, dans lequel l'étape de gravure de la portion de matériau (1002) recouvrant le dispositif microélectronique (1000) et l'étape d'élimination d'une partie de la couche de matériau organique (104) correspondent à une seule étape de gravure sèche.

15. Procédé selon la revendication 12, comportant en outre, entre l'étape de réalisation du dispositif microélectronique (1000) et l'étape d'élimination d'une partie de la couche de matériau organique (104), une étape de report et de scellement d'un capot (1020) sur la couche supérieure (106), dans lequel l'élimination d'une partie de la couche de matériau organique (104) est réalisée par au moins une ouverture (1026) formée à travers le capot (1020), et comportant en outre une étape de fermeture hermétique de l'ouverture (1026) réalisée à travers le capot (1020).

## Patentansprüche

1. Mikroelektronisches Substrat (100-400), das wenigstens umfasst:
- eine Trägerschicht (102),
- eine obere Schicht (106), die aus wenigstens einem Halbleiter gebildet ist,
- eine Schicht (104), die aus wenigstens einem organischen Material gebildet ist, welches dazu ausgelegt ist, bezüglich des Halbleiters der oberen Schicht (106) selektiv graviert zu werden durch Verwendung einer Trockengravur, und die zwischen der Trägerschicht (102) und der oberen Schicht (106) angeordnet ist, **dadurch gekennzeichnet, dass** es ferner einen oder mehrere Bereiche (402, 408, 410) aus dielektrischem Material umfasst, deren Härte größer ist als jene des organischen Materials, die in der Schicht aus organischem Material (104) angeordnet sind und deren Dicke im Wesentlichen gleich jener der Schicht aus organischem Material (104) ist.

2. Mikroelektronisches Substrat (100-400) nach Anspruch 1, bei dem das organische Material ein fotoempfindliches Harz ist.

3. Mikroelektronisches Substrat (200, 300) nach einem der vorhergehenden Ansprüche, ferner umfassend wenigstens eine Schicht aus Gettermaterial (202), die zwischen der Trägerschicht (102) und der Schicht aus organischem Material (104) angeordnet ist.

4. Mikroelektronisches Substrat (300) nach einem der vorhergehenden Ansprüche, ferner umfassend wenigstens zwei weitere Schichten (302a, 302b), die direkt miteinander verbunden und zwischen der Schicht aus organischem Material (104) und der oberen Schicht (106) angeordnet sind.

5. Mikroelektronisches Substrat (400) nach einem der vorhergehenden Ansprüche, bei dem wenigstens einer der Bereiche (408, 410) aus dielektrischem Material, die in der Schicht aus organischem Material (104) angeordnet sind, eine geschlossene Kontur um wenigstens eine Region (406) der Schicht aus organischem Material (104) herum bildet.

6. Mikroelektronische Vorrichtung (1000), umfassend ein mikroelektronisches Substrat (100-400) nach einem der vorhergehenden Ansprüche, umfassend wenigstens einen Bereich der oberen Schicht (106), der über der Trägerschicht (102) aufgehängt ist.

7. Verfahren zur Herstellung eines mikroelektronischen Substrats (100-400), umfassend wenigstens die folgenden Schritte:
- Herstellung einer Schicht (104), die aus wenigstens einem organischen Material gebildet ist, auf einer Trägerschicht (102);
- Herstellung einer oberen Schicht (106), die aus wenigstens einem Halbleiter gebildet ist, auf der Schicht aus organischem Material (104), wobei das organische Material dazu ausgelegt ist, bezüglich des Halbleiters der oberen Schicht (106) selektiv graviert zu werden durch Verwendung einer Trockengravur;
**dadurch gekennzeichnet, dass** es ferner, vor der Herstellung der Schicht aus organischem Material (104), einen Schritt der Herstellung eines oder mehrerer Bereiche (402, 408, 410) aus einem dielektrischen Material auf der Trägerschicht (102) umfasst, deren Härte größer ist als jene des organischen Materials, deren Dicke im Wesentlichen gleich jener der Schicht aus organischem Material (104) ist, wobei die Schicht aus organischem Material (104) anschließend auf der Trägerschicht (102) um den oder die Bereich(e) (402, 408, 410) herum hergestellt wird.

8. Verfahren nach Anspruch 7, ferner umfassend, vor der Herstellung der Schicht aus organischem Material (104), einen Schritt der Herstellung wenigstens einer Schicht aus Gettermaterial (202) auf der Trägerschicht (102), wobei die Schicht aus organischem Material (104) und der oder die Bereich(e) (402, 408, 410) aus dielektrischem Material auf der Schicht aus Gettermaterial (202) hergestellt werden.

9. Verfahren nach einem der Ansprüche 7 oder 8, bei dem die Herstellung der oberen Schicht (106) auf der Schicht aus organischem Material (104) wenigstens einen Schritt des direkten Klebens zwischen zwei weiteren Schichten (302a, 302b) umfasst, von denen die eine (302b) an der oberen Schicht (106) und die andere (302a) an der Schicht aus organischem Material (104) angeordnet wird.

10. Verfahren nach einem der Ansprüche 7 bis 9, ferner umfassend, vor der Herstellung der oberen Schicht (106), einen Schritt der Herstellung eines oder mehrerer Löcher (404) durch die Schicht aus organischem Material (104) hindurch.

11. Verfahren nach einem der Ansprüche 7 bis 10, ferner umfassend die Herstellung wenigstens eines der Bereiche (408, 410) aus dielektrischem Material derart, dass der Bereich (408, 410) eine geschlossene Kontur um wenigstens eine Region (406) der Schicht aus organischem Material (104) herum bildet.

12. Verfahren zur Herstellung wenigstens einer mikroelektronischen Vorrichtung (1000), wenigstens umfassend die folgenden Schritte:
- Herstellung der mikroelektronischen Vorrichtung (1000) in der oberen Schicht (106) eines mikroelektronischen Substrats (100-400) nach einem der Ansprüche 1 bis 5;
- Entfernen eines Teils der Schicht aus organischem Material (104), der unter der mikroelektronischen Vorrichtung (1000) angeordnet ist, durch Trockengravur derart, dass die mikroelektronische Vorrichtung (1000) wenigstens einen Bereich der oberen Schicht (106) umfasst, der über der Trägerschicht (102) aufgehängt ist.

13. Verfahren nach Anspruch 12, ferner umfassend, zwischen dem Schritt der Herstellung der mikroelektronischen Vorrichtung (1000) und dem Schritt des Entfernens eines Teils der Schicht aus organischem Material (104) wenigstens die folgenden Schritte:
- Herstellen, auf der oberen Schicht (106) des mikroelektronischen Substrats (100-400), eines Bereichs aus Material (1002), das dazu ausgelegt ist, bezüglich des Halbleitermaterials der oberen Schicht (106) selektiv graviert zu werden, und die mikroelektronische Vorrichtung (1000) bedeckt,
- Aufbringen wenigstens einer Kapselungsschicht (1004) auf dem Bereich aus Material (1002), der die mikroelektronische Vorrichtung (1000) bedeckt;
- Gravieren des Bereichs aus Material (1002), der die mikroelektronische Vorrichtung (1000) bedeckt, durch wenigstens eine Öffnung (1006) hindurch, die durch die Kapselungsschicht (1004) hindurch realisiert ist;
und ferner umfassend, nach dem Schritt des Entfernens eines Teils der Schicht aus organischem Material (104), der unter der mikroelektronischen Vorrichtung (1000) angeordnet ist, einen Schritt des hermetischen Schließens der Öffnung(en) (1006), die durch die Kapselungsschicht (1004) hindurch realisiert ist/sind.

14. Verfahren nach Anspruch 13, bei dem der Schritt des Gravierens des Bereichs aus Material (1002), der die mikroelektronische Vorrichtung (1000) bedeckt, und der Schritt des Entfernens eines Teils der Schicht aus organischem Material (104) einem einzigen Trockengravurschritt entsprechen.

15. Verfahren nach Anspruch 12, ferner umfassend, zwischen dem Schritt der Herstellung der mikroelektronischen Vorrichtung (1000) und dem Schritt des Entfernens eines Teils der Schicht aus organischem Material (104), einen Schritt des Aufbringens und Versiegelns einer Kappe (1020) auf der oberen Schicht (106), wobei das Entfernen eines Teils der Schicht aus organischem Material (104) durch wenigstens eine Öffnung (1026) realisiert wird, welche durch die Kappe (1020) hindurch gebildet ist, und ferner umfassend einen Schritt des hermetischen Schließens der Öffnung (1026), die durch die Kappe (1020) hindurch realisiert ist.

## Claims

1. A microelectronic substrate (100-400) comprising at least:
- a support layer (102),
- a top layer (106) comprising at least one semiconductor,
- a layer (104) comprising at least one organic material able to be etched selectively with respect to the semiconductor of the top layer (106) by using a dry etching, and arranged between the support layer (102) and the top layer (106),
**characterized in that** it also comprises one or more portions (402, 408, 410) of dielectric material the hardness of which is greater than that of the organic material, arranged in the layer (104) of organic material, and the thickness of which is substantially equal to that of the layer (104) of organic material.

2. The microelectronic substrate (100-400) according to claim 1, in which the organic material is a photosensitive resin.

3. The microelectronic substrate (100-400) according to one of previous claims, also comprising at least one layer (202) of getter material arranged between the support layer (102) and the layer (104) of organic material.

4. The microelectronic substrate (300) according to one of previous claims, also comprising at least two other layers (302a, 302b) fixed directly against each other and arranged between the layer (104) of organic material and the top layer (106).

5. The microelectronic substrate (400) according to one of previous claims, in which at least one of the portions (408, 410) of dielectric material arranged in the layer (104) of organic material forms a closed contour around at least one region (406) of the layer (104) of organic material.

6. A microelectronic device (1000) comprising a microelectronic substrate (100-400) according to one of previous claims, comprising at least one portion of the top layer (106) suspended above the support layer (102).

7. A method of producing a microelectronic substrate (100-400), comprising at least the steps of:
- producing a layer (104) comprising at least one organic material on a support layer (102);
- producing a top layer (106) comprising at least one semiconductor on the layer (104) of organic material, the organic material being able to be etched selectively with respect to the semiconductor of the top layer (106) using a dry etching;
**characterized in that** it also comprises, before the production of the layer (104) of organic material, a step of producing one or more portions (402, 408, 410) of a dielectric material the hardness of which is greater than that of the organic material, on the support layer (102), the thickness of which is substantially equal to that of the layer (104) of organic material, the layer (104) of organic material then being produced on the support layer (102), around said portion or portions (402, 408, 410).

8. The method according to claim 7, also comprising, before the production of the layer (104) of organic material, a step of producing at least one layer (202) of getter material on the support layer (102), the layer (104) of organic material and the portion or portions (402, 408, 410) of dielectric material being produced on the layer of getter material (202).

9. The method according to one of claims 7 and 8, in which the production of the top layer (106) on the layer (104) of organic material comprises at least one step of direct bonding between two other layers (302a, 302b), one (302b) being disposed against the top layer (106) and the other (302a) being disposed against the layer (104) of organic material.

10. The method according to one of claims 7 to 9, also comprising, before the production of the top layer (106), a step of producing one or more holes (404) through the layer (104) of organic material.

11. The method according to one of claims 7 to 10, also comprising the production of at least one of the portions (408, 410) of dielectric material such that said portion (408, 410) forms a closed contour around at least one region (406) of the layer (104) of organic material.

12. A method of producing at least one microelectronic device (1000), comprising at least the steps of:
- producing the microelectronic device (1000) in the top layer (106) of a microelectronic substrate (100-400) according to one of claims 1 to 5;
- elimination by dry etching of part of the layer (104) of organic material arranged under the microelectronic device (1000) so that the microelectronic device (1000) comprises at least one portion of the top layer (106) suspended above the support layer (102).

13. The method according to claim 12, comprising in addition, between the step of producing the microelectronic device (1000) and the step of eliminating part of the layer (104) of organic material, at least the steps of:
- producing, on the top layer (106) of the microelectronic substrate (100-400), a portion (1002) of material able to be etched selectively with respect to the semiconductor material of the top layer (106) and covering the microelectronic device (1000);
- depositing at least one encapsulation layer (1004) on the portion (1002) of material covering the microelectronic device (1000);
- etching the portion (1002) of material covering the microelectronic device (1000) through at least one opening (1006) produced through the encapsulation layer (1004);
and also comprising, after the step of elimination of part of the layer (104) of organic material arranged under the microelectronic device (1000), a step of hermetic closure of the opening or openings (1006) produced through the encapsulation layer (1004).

14. The method according to claim 13, in which the step of etching the portion (1002) of material covering the microelectronic device (1000) and the step of eliminating part of the layer (104) of organic material are a single dry etching step.

15. The method according to claim 12, also comprising, between the step of producing the microelectronic device (1000) and the step of eliminating part of the layer (104) of organic material, a step of transfer and sealing of a cap (1020) on the top layer (106), in which the elimination of part of the layer (104) of organic material is carried out through at least one opening (1026) formed through the cap (1020), and also comprising a step of hermetic closure of the opening (1026) carried out through the cap (1020).
